# EUROPEAN PATENT APPLICATION

(11) **EP 4 376 052 A1**
(43) Date of publication of application: **29.05.2024**
(21) Application number: 21916641.0
(22) Date of filing: 01.09.2021

(54) **FLEXIBLE COVER PLATE AND FLEXIBLE DISPLAY APPARATUS**

(30) Priority: 22.07.2021 CN 202110830212
(71) Applicant: Wuhan China Star Optoelectronics Semiconductor Display Technology Co., Ltd., Wuhan, Hubei 430070 (CN)
(72) Inventor: XU, Feng, Wuhan, Hubei 430079 (CN)
(74) Representative: Murgitroyd & Company
(86) International application number: PCT/CN2021/115905
(87) International publication number: WO 2023/000445

(57) **Abstract**

The present application provides a flexible cover plate and a flexible display device. The flexible cover plate includes a bending region, a non-bending region, and a transition region. The transition region is connected to the non-bending region and the bending region. The flexible cover plate further includes: a substrate layer; and a hardened layer formed on the substrate layer. A thickness of a portion of the hardened layer in the bending region is less than a thickness of a portion of the hardened layer in the non-bending region. A thickness of a portion of the substrate layer in the bending region is greater than a thickness of a portion of the substrate layer in the non-bending region. The flexible cover plate of the present application can simultaneously have high strength and high bending capability.

## Description

### FIELD OF INVENTION

The present application relates to a field of display technologies, especially to a flexible cover plate and a flexible display device.

### BACKGROUND OF INVENTION

Flexible organic light emitting diode (OLED) technology is considered a display technology for a new generation. A cover plate, serving as a protective layer for an outermost layer of a flexible OLED, needs excellent bending capability. A material usually used for for a cover plate is an organic substrate laminated with a hardened layer. The organic substrate usually uses transparent polyimide ( also called colorless polyimide, CPI). To have better bending capability, it is needed to reduce thicknesses of the organic substrate layer and the hardened layer of the cover plate. However, hardness and an impact resistance ability of the cover plate with the reduced thickness are weakened. Furthermore, when the thickness of the hardened layer is thicker, repeatedly bending the hardened layer easily results in cracks on the hardened layer and even breaks the hardened layer.

### SUMMARY OF INVENTION

### Technical issue

Therefore, a conventional cover plate cannot simultaneously have high strength and high bending capability.

### Technical solution

To solve above issues, technical solutions provided by the present application are as follows:

The present application provides a flexible cover plate comprising a bending region, a non-bending region, and a transition region, wherein the transition region is connected to the non-bending region and the bending region; wherein the flexible cover plate further comprises:
at least one substrate layer; and
at least one hardened layer formed on the substrate layer;
   wherein a thickness of a portion of the hardened layer located in the bending region is less than a thickness of a portion of the hardened layer located in the non-bending region, and a thickness of a portion of the substrate layer located in the bending region is greater than a thickness of a portion of the substrate layer located in the non-bending region.

In an optional embodiment of the present application, the thickness of the portion of the hardened layer located in the bending region is less than the thickness of the portion of the substrate layer located in the bending region.

In an optional embodiment of the present application, the substrate layer comprises a first bending portion, a first non-bending portion, and a first transition portion, and the first transition portion is connected to the first non-bending portion and the first bending portion; and the hardened layer comprises a second bending portion, a second non-bending portion, and a second transition portion, and the second transition portion is connected to the second non-bending portion and the second bending portion;
wherein the first bending portion and the second bending portion are located in the bending region, the first non-bending portion and the second non-bending portion are located in the non-bending region, and the first transition portion and the second transition portion are located in the transition region; and
wherein the second bending portion is formed correspondingly on the first bending portion, the second non-bending portion is formed correspondingly on the first non-bending portion, and the second transition portion is formed correspondingly on the first transition portion.

In an optional embodiment of the present application, a thickness of the first bending portion is greater than a thickness of the first non-bending portion; and a thickness of the second bending portion is less than a thickness of the second non-bending portion.

In an optional embodiment of the present application, the thickness of the first bending portion is greater than the thickness of the second bending portion.

In an optional embodiment of the present application, a thickness of the first transition portion evenly increases from the thickness of the first non-bending portion to the thickness of the first bending portion.

In an optional embodiment of the present application, a ratio of a difference between a maximum thickness and a minimum thickness of the first transition portion to a width of the first transition portion is defined as a thickness variation rate of the first transition portion, and the thickness variation rate of the first transition portion is less than or equal to 1/3.

In an optional embodiment of the present application, a thickness of the second transition portion evenly decreases from the thickness of the second non-bending portion to the thickness of the second bending portion.

In an optional embodiment of the present application, a ratio of a difference between a maximum thickness and a minimum thickness of the second transition portion to a width of the second transition portion is defined as a thickness variation rate of the second transition portion, and the thickness variation rate of the second transition portion is less than or equal to 1/3.

In an optional embodiment of the present application, a thickness of the first bending portion is 50-100um, and a thickness of the first non-bending portion is 30-70um.

In an optional embodiment of the present application, a thickness of the second bending portion is 3-30um, and the thickness of the second non-bending portion is 30-60um.

In an optional embodiment of the present application, a material of the substrate layer is at least one of polymethyl methacrylate (PMMA), transparent polyimide, polyethylene glycol terephthalate (PET), or siloxane.

In an optional embodiment of the present application, a material of the hardened layer is at least one of polymethyl methacrylate (PMMA), polyimide, polyethylene glycol terephthalate (PET), and organosilicon compound.

In an optional embodiment of the present application, thicknesses of the flexible cover plate located in the bending region, the transition region, and the non-bending region respectively are the same.

In an optional embodiment of the present application, the substrate layer comprises a first surface, the hardened layer comprises a second surface, the first surface is bonded to the second surface, and the first surface and the second surface are rough surfaces.

In an optional embodiment of the present application, the first surface and the second surface have micro structures.

The present application also provides a flexible display device comprising a display panel, the flexible display device further comprises the flexible cover plate as described above, and the substrate layer of the flexible cover plate is formed on the display panel.

### Advantages

Advantages of the present application are as follows: The flexible cover plate provided by the present application unevenly disposes thicknesses of at least one hardened layer and at least one substrate layer in the bending region, the non-bending region, and the transition region to simultaneously have high strength and high bending capability. Specifically, reducing the thickness of the hardened layer in the bending region relative to the thickness of the hardened layer in the non-bending region can lower a risk of the hardened layer broken or cracked. The non-bending region of the hardened layer keeps the thickness in a certain degree, which facilitates improvement of the strength and surface characteristics of the cover plate. The thicknesses of the substrate layer of the flexible cover plate are unevenly disposed in the bending region, the non-bending region, and the transition region, and the thickness of the substrate layer in the bending region is increased relative to the thickness of the substrate layer in the bending region, which facilitates flatness of the entire flexible cover plate.

### DESCRIPTION OF DRAWINGS

To more clearly elaborate on the technical solutions of embodiments of the present invention or prior art, appended figures necessary for describing the embodiments of the present invention or prior art will be briefly introduced as follows. Apparently, the following appended figures are merely some embodiments of the present invention. A person of ordinary skill in the art may acquire other figures according to the appended figures without any creative effort.
FIG. 1 is a schematic view of a flexible display device provided by the present application.
FIG. 2 is a schematic view of a flexible display device provided by a second embodiment of the present application.

### DETAILED DESCRIPTION OF PREFERRED EMBODIMENTS

The technical solution in the embodiment of the present application will be clearly and completely described below with reference to the accompanying drawings in the embodiments of the present application. Apparently, the described embodiments are merely some embodiments of the present application instead of all embodiments. According to the embodiments in the present application, all other embodiments obtained by those skilled in the art without making any creative effort shall fall within the protection scope of the present application.

In the description of the present application, it should be understood that terminologies "upper" and "lower" for indicating relations of orientation or position are based on orientation or position of the accompanying drawings, are only for the purposes of facilitating description of the present application and simplifying the description instead of indicating or implying that the referred device or element must have a specific orientation or position, must to be structured and operated with the specific orientation or position. Therefore, they should not be understood as limitations to the present application. Furthermore, terminologies "first", "second" are only for the purposes of description, and cannot be understood as indication or implication of comparative importance or a number of technical features. Therefore, a feature limited with "first", "second" can expressly or implicitly include one or more features. In the description of the present application, a meaning of "a plurality of" is two or more, unless there is a clear and specific limitation otherwise.

Furthermore, the present application may repeat reference numerals and/or reference letters in different embodiments. The repetition is for the purpose of simplification and clarity, and does not by itself indicate the relationship between the various embodiments and/or settings discussed.

The present application aims at a technical issue that a conventional cover plate cannot simultaneously have high strength and high bending capability. With an uneven arrangement of disposing thicknesses of a hardened layer and a substrate layer in a bending region, a non-bending region, and a transition region, the present application allows a flexible cover plate to simultaneously have high strength and high bending capability. Specifically, by keeping the thickness of the hardened layer in the non-bending region in a certain degree, reducing the thickness of the hardened layer in the bending region relative to the thickness of the hardened layer in the non-bending region, and increasing the thickness of the substrate layer in the bending region relative to the thickness of the substrate layer in the non-bending region, the present application not only lowers a risk of breaking or cracking the hardened layer, but also facilitates improvement of strength and surface characteristics of the cover plate, and is also advantageous to flatness of an entire flexible cover plate.

The flexible cover plate and the flexible display device of the present application would be described in detail combining with specific embodiments as follows.

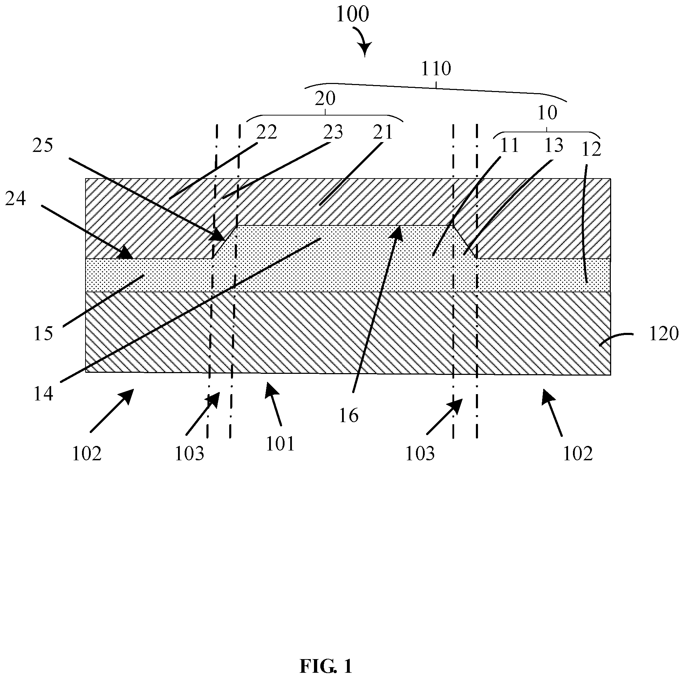

With reference to FIG. 1, a preferred embodiment of the present application provides a flexible display device 100. The flexible display device 100 can be a display screen, an organic light emitting diode display, a computer, a cell phone, etc.

The flexible display device 100 comprises a flexible cover plate 110 and a display panel 120. The flexible cover plate 110 is formed on the display panel 120.

The flexible cover plate 110 comprises a bending region 101, a non-bending region 102, and a transition region 103. The transition region 103 is connected to the non-bending region 102 the bending region 101. In the present embodiment, the flexible cover plate 110 comprises one bending region 101, two non-bending regions 102, and two transition regions 103.

The flexible cover plate 110 comprises at least one substrate layer 10 and at least one hardened layer 20. The hardened layer 20 is formed on the substrate layer 10.

Thicknesses of portions of the substrate layer 10 in the bending region 101, the non-bending region 102, and the transition region 103 are unequal. Specifically, the thickness of the portion of the substrate layer 10 located in the bending region 101 is greater than the thickness of the portion of the substrate layer 10 located in the non-bending region 102. The thickness of the portion of the substrate layer 10 located in the transition region 103 is greater than the thickness of the portion of the substrate layer 10 located in the non-bending region 102 and is less than the thickness of the portion of the substrate layer 10 located in the bending region 101.

Thicknesses of portions of the hardened layer 20 in the bending region 101, the non-bending region 102, and the transition region 103 are unequal. Specifically, the thickness of the portion of the hardened layer 20 located in the bending region 101 is less than the thickness of the portion of the hardened layer 20 located in the non-bending region 102. The thickness of the portion of the hardened layer 20 located in the transition region 103 is less than the thickness of the portion of the hardened layer 20 located in the non-bending region 102 and is greater than the thickness of the portion of the hardened layer 20 located in the bending region 101.

In an optional embodiment of the present application, a material of the substrate layer 10 is at least one of polymethyl methacrylate (PMMA), transparent polyimide, polyethylene glycol terephthalate (PET), siloxane, etc. In the present embodiment, the material of the substrate layer 10 is transparent polyimide.

The substrate layer 10 comprises a first bending portion 11, a first non-bending portion 12, and a first transition portion 13. The first transition portion 13 is connected to the first non-bending portion 12 and the first bending portion 11. The first bending portion 11 is located in the bending region 101, the first non-bending portion 12 is located in the non-bending region 102, and the first transition portion 13 is located in the transition region 103.

A thickness of the first bending portion 11 is greater than a thickness of the first non-bending portion 12, and a thickness of the first transition portion 13 increases from the thickness of the first non-bending portion 12 to the thickness of the first bending portion 11. In the present embodiment, an outline surface of the first transition portion 13 is flat. The thickness of the first transition portion 13 evenly increases from the thickness of the first non-bending portion 12 to the thickness of the first bending portion 11 such that a force on the first transition portion 13 changes smoothly and continuously during a bending process, thereby preventing a sudden change of a stress of the first transition portion 13. Uneven variation of the first transition portion 13 would cause the sudden change of the stress of the first transition portion 13, which easily causes cracks. Furthermore, a manufacturing process for the uneven variation of the first transition portion 13 is difficult to control, which is disadvantageous to manufacture.

In an optional embodiment of the present application, the thickness of the first bending portion 11 is 50-100um. The first bending portion 11 within a thickness range of 50-100um has better bending capability to fulfill bending demands of the flexible cover plate 110 from small bending radius to large bending radiuses such that the first bending portion 11 is not cracked during bending. Furthermore, the first bending portion 11 within the thickness range of 50-100um has the thickness in a certain degree, which can guarantee that the flexible cover plate 110 has certain strength.

In an optional embodiment of the present application, the thickness of the first non-bending portion 12 is 30-70um. The portion of the flexible cover plate 110 in the non-bending region 102 requires no bending. Therefore, a second non-bending portion 22 of the hardened layer 20 in the non-bending region 102 requires no thickness reduction. To guarantee consistency of thicknesses of portions of the flexible cover plate 110 in different regions, the thickness of the first non-bending portion 12 can be less than the thickness of the first bending portion 11. The thickness of the first non-bending portion 12 is set in a range of 30-70um, which can fulfill demands of a total thickness and strength of the flexible cover plate 110.

In an optional embodiment of the present application, a ratio of a difference between a maximum thickness and a minimum thickness of the first transition portion 13 to a width of the first transition portion 13 is defined as a thickness variation rate of the first transition portion 13. Then, the thickness variation rate of the first transition portion 13 is less than or equal to 1/3 to guarantee that the first transition portion 13 has more gentle variation to optimize optical performance of the flexible cover plate 110. Furthermore, the thickness variation rate of the first transition portion 13 is less than or equal to 1/3, which can prevent some optical anomaly such as an observable gap.

Of course, in another optional embodiment of the present application, because the flexible cover plate 110 is composed of two materials of the substrate layer and the hardened layer, when refractive indexes of the substrate layer and the hardened layer are same, exiting light on a contact interface between the substrate layer and the hardened layer would not be refracted, which can reduce changes in a direction of the exiting light. Therefore, when the refractive indexes of the materials of the substrate layer 10 and the hardened layer 20 are the same, the flexible cover plate 110 has better optical performance. At this time, the present application does not limit the thickness variation rate of the first transition portion 13 of the substrate layer 10 to be less than or equal to 1/3.

In the present embodiment, the thickness of the first bending portion 11 is 100um, the thickness of the first non-bending portion 12 is 60um, and the thickness of the first transition portion 13 evenly varies from 60um to 100um. When the thicknesses of the first bending portion 11 and the first non-bending portion 12 employs above values, the flexible cover plate 110 has better optical performance.

The substrate layer 10 further comprises a first body 15 and a protrusion 14 extending from the first body 15. The first body 15 is located in the bending region 101, the non-bending region 102, and the transition region 103. The protrusion 14 is located in the bending region 101 and the transition region 103. In the present embodiment, the protrusion 14 and the first body 15 are formed integrally. In the present embodiment, the protrusion 14 is trapezoidal. Specifically, a portion of the first body 15 located in the non-bending region 102 is the first non-bending portion 12. A portion of the first body 15 located in the bending region 101 and a portion of the protrusion 14 located in the bending region 101 are the first bending portion 11. A portion of the first body 15 located in the transition region 103 and a portion of the protrusion 14 located in the transition region 103 are the first transition portion 13.

The substrate layer 10 further comprises a first surface 16 facing the hardened layer 20. The first surface 16 is located in the bending region 101, the non-bending region 102, and the transition region 103. The first surface 16 is composed of surfaces of the first bending portion 11, the first non-bending portion 12, and the first transition portion 13 facing the hardened layer 20.

In an optional embodiment of the present application, the first surface 16 is a rough surface. Specifically, first micro structures (not shown in the figures) can be further formed on the first surface 16. The first micro structures can increase a contact area between the substrate layer 10 and the hardened layer 20 to increase a bonding force between the substrate layer 10 and the hardened layer 20.

The substrate layer 10 can be formed on the display panel 120 by a spray coating process and shaped by a thermal curing process, a UV curing process, or a thermal curing plus UV curing process.

In an optional embodiment of the present application, a material of the hardened layer 20 is at least one of polymethyl methacrylate (PMMA), polyimide, polyethylene glycol terephthalate (PET), or organosilicon compound.

The hardened layer 20 comprises a second bending portion 21, a second non-bending portion 22, and a second transition portion 23. The second transition portion 23 is connected to the second non-bending portion 22 and the second bending portion 21. The second bending portion 21 is located in the bending region 101. The second non-bending portion 22 is located in the non-bending region 102. The second transition portion 23 is located in the transition region 103.

The second bending portion 21 is correspondingly formed on the first bending portion 11. The second non-bending portion 22 is correspondingly formed on the first non-bending portion 12. The second transition portion 23 is correspondingly formed on the first transition portion 13.

A thickness of the second bending portion 21 is less than a thickness of the second non-bending portion 22. A thickness of the second transition portion 23 decreases from the thickness of the second non-bending portion 22 to the thickness of the second bending portion 21. In the present embodiment, an outline surface of the second transition portion 23 is flat, and the thickness of the second transition portion 23 evenly decreases from the thickness of the second non-bending portion 22 to the thickness of the second bending portion 21.

In an optional embodiment of the present application, the thickness of the second bending portion 21 is 3-30um. The second bending portion 21 within a thickness range of 3-30um has better bending capability to fulfill bending demands of the flexible cover plate 110 from small bending radiuses to large bending radiuses such that the second bending portion 21 is not broken during bending. Furthermore, the second bending portion 21 in the thickness range of 3-30um has better strength to guarantee that the flexible cover plate 110 has certain strength. Furthermore, the second bending portion 21 adopting the above thickness range can fulfill a conventional manufacturing process of coating and forming the hardened layer 20 on the substrate layer 10.

In an optional embodiment of the present application, the thickness of the second non-bending portion 22 is 30-60um to provide the flexible cover plate 110 with strength needed, and combines the first non-bending portion 12 such that the thicknesses of the portions of the flexible cover plate 110 in different regions are consistent, which facilitates flatness of the entire flexible cover plate.

In an optional embodiment of the present application, a ratio of a difference between a maximum thickness and a minimum thickness of the second transition portion 23 to a width of the second transition portion 23 is defined as a thickness variation rate of the second transition portion 23. The thickness variation rate of the second transition portion 23 is less than or equal to 1/3 to guarantee that the second transition portion 23 has more gentle variation to optimize the optical performance of the flexible cover plate 110. Furthermore, the thickness variation rate of the second transition portion 23 is less than or equal to 1/3, which can prevent some optical anomaly such as the observable gap.

In the present embodiment, the thickness of the second bending portion 21 is 10um. The thickness of the second non-bending portion 22 is 50um. The thickness of the second transition portion 23 evenly varies from 10um to 50um. When the thicknesses of the second bending portion 21 and second non-bending portion 22 employ the above values, the flexible cover plate 110 has better optical performance.

The hardened layer 20 further comprises a second surface 24, and the second surface 24 faces the substrate layer 10 and is bonded to the first surface 16. Specifically, the second surface 24 is located in the bending region 101, the non-bending region 102, and the transition region 103. The second surface 24 is composed of surfaces of the second bending portion 21, the second non-bending portion 22, and the second transition portion 23 facing the substrate layer 10.

In an optional embodiment of the present application, the second surface 24 is a rough surface. Specifically, second micro structures (not shown in the figures) are formed on the second surface 24. The second micro structures are engaged with the first micro structures to increase the contact area between the substrate layer 10 and the hardened layer 20 to increase the bonding force between the substrate layer 10 and the hardened layer 20.

The hardened layer 20 further comprises an accommodation recess 25. The accommodation recess 25 is recessed and formed from the second surface 24 to an inside of the hardened layer 20. The protrusion 14 is accommodated in the accommodation recess 25.

In an optional embodiment of the present application, the thicknesses of the portions of the flexible cover plate 110 located in the bending region 101, the transition region 103, and the non-bending region 102 are same. Specifically, a sum of the thicknesses of the first bending portion 11 and the second bending portion 21 is equal to a sum of the thicknesses of the first non-bending portion 12 and the second non-bending portion 22, and is equal to a sum of the thicknesses of the first transition portion 13 and the second transition portion 23.

The hardened layer 20 can be formed on the substrate layer 10 by the spray coating process and shaped by the thermal curing process, the ultraviolet (UV) curing process, or the thermal curing plus UV curing process.

The display panel 120 can be an organic light emitting diode (OLED) display panel, a liquid crystal display panel, or a microLED display panel.

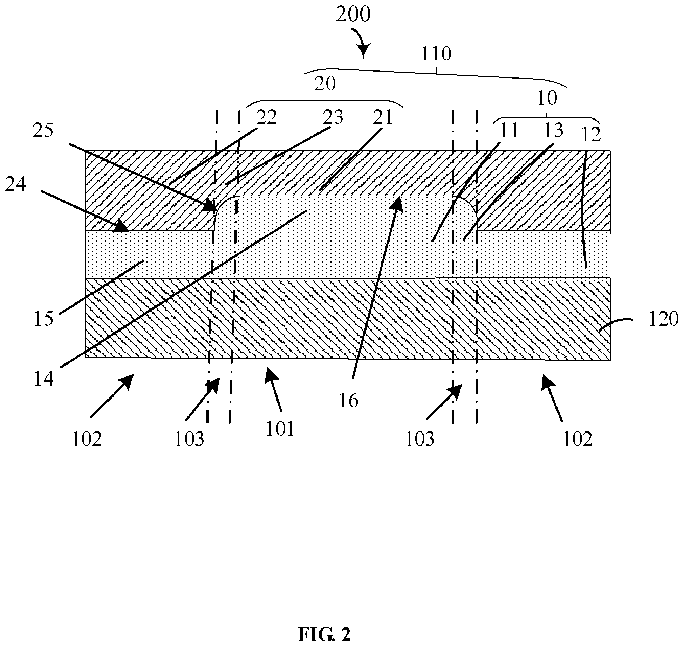

With reference to FIG. 2, the present application provides a flexible cover plate 200. Structures of the flexible cover plate 200 and the flexible cover plate 110 are basically same, and a difference of the structures of the flexible cover plate 200 and the flexible cover plate 110 is as follows: the outline surfaces of the first transition portion 13 and the second transition portion 23 of the flexible cover plate 200 are curved surfaces to enhance the bonding force between the substrate layer 10 and the hardened layer 20. In the present embodiment, the outline surface is an arc. In other embodiment, the outline surface can also be a curved surface composed of a plurality of curved surfaces, which can enhance the bonding force between the substrate layer 10 and the hardened layer 20.

Advantages of the present application are as follows: the thicknesses of at least one hardened layer and at least one substrate layer of the flexible cover plate provided by the present application in the bending region, the non-bending region, and the transition region are set unevenly to simultaneously have high strength and high bending capability. Specifically, reducing the thickness of the hardened layer in the bending region relative to the thickness of the hardened layer in the non-bending region can lower a risk of breaking or cracking the hardened layer. The non-bending region of the hardened layer keeps the thickness in a certain degree, which facilitates improvement of the strength and surface characteristics of the cover plate. The thicknesses of the substrate layer of the flexible cover plate are unevenly set in the bending region, the non-bending region, and the transition region, and the thickness of the substrate layer in the bending region is increased relative to the thickness of the substrate layer in the non-bending region, which facilitates flatness of the entire flexible cover plate.

Although the preferred embodiments of the present invention have been disclosed as above, the aforementioned preferred embodiments are not used to limit the present invention. The person of ordinary skill in the art may make various changes and modifications without departing from the spirit and scope of the present invention. Therefore, the scope of protection of the present invention is defined by the scope of the claims.

## Claims

1. A flexible cover plate comprising a bending region, a non-bending region, and a transition region, wherein the transition region is connected to the non-bending region and the bending region; wherein the flexible cover plate further comprises:
at least one substrate layer; and
at least one hardened layer formed on the substrate layer;
wherein a thickness of a portion of the hardened layer located in the bending region is less than a thickness of a portion of the hardened layer located in the non-bending region, and a thickness of a portion of the substrate layer located in the bending region is greater than a thickness of a portion of the substrate layer located in the non-bending region.

2. The flexible cover plate according to claim 1, wherein the thickness of the portion of the hardened layer located in the bending region is less than the thickness of the portion of the substrate layer located in the bending region.

3. The flexible cover plate according to claim 1, wherein the substrate layer comprises a first bending portion, a first non-bending portion, and a first transition portion, and the first transition portion is connected to the first non-bending portion and the first bending portion; the hardened layer comprises a second bending portion, a second non-bending portion, and a second transition portion, and the second transition portion is connected to the second non-bending portion and the second bending portion;
wherein the first bending portion and the second bending portion are located in the bending region, the first non-bending portion and the second non-bending portion are located in the non-bending region, and the first transition portion and the second transition portion are located in the transition region; and
wherein the second bending portion is formed correspondingly on the first bending portion, the second non-bending portion is formed correspondingly on the first non-bending portion, and the second transition portion is formed correspondingly on the first transition portion.

4. The flexible cover plate according to claim 3, wherein a thickness of the first bending portion is greater than a thickness of the first non-bending portion; and a thickness of the second bending portion is less than a thickness of the second non-bending portion.

5. The flexible cover plate according to claim 4, wherein the thickness of the first bending portion is greater than the thickness of the second bending portion.

6. The flexible cover plate according to claim 3, wherein a thickness of the first transition portion evenly increases from the thickness of the first non-bending portion to the thickness of the first bending portion.

7. The flexible cover plate according to claim 6, wherein a ratio of a difference between a maximum thickness and a minimum thickness of the first transition portion to a width of the first transition portion is defined as a thickness variation rate of the first transition portion, and the thickness variation rate of the first transition portion is less than or equal to 1/3.

8. The flexible cover plate according to claim 3, wherein a thickness of the second transition portion evenly decreases from the thickness of the second non-bending portion to the thickness of the second bending portion.

9. The flexible cover plate according to claim 8, wherein a ratio of a difference between a maximum thickness and a minimum thickness of the second transition portion to a width of the second transition portion is defined as a thickness variation rate of the second transition portion, and the thickness variation rate of the second transition portion is less than or equal to 1/3.

10. The flexible cover plate according to claim 3, wherein a thickness of the first bending portion is 50-100um, and a thickness of the first non-bending portion is 30-70um.

11. The flexible cover plate according to claim 3, wherein a thickness of the second bending portion is 3-30um, and the thickness of the second non-bending portion is 30-60um.

12. The flexible cover plate according to claim 1, wherein a material of the substrate layer is at least one of polymethyl methacrylate (PMMA), transparent polyimide, polyethylene glycol terephthalate (PET), or siloxane.

13. The flexible cover plate according to claim 1, wherein a material of the hardened layer is at least one of polymethyl methacrylate (PMMA), polyimide, polyethylene glycol terephthalate (PET), and organosilicon compound.

14. The flexible cover plate according to claim 1, wherein thicknesses of the flexible cover plate located in the bending region, the transition region, and the non-bending region respectively are same.

15. The flexible cover plate according to claim 1, wherein the substrate layer comprises a first surface, the hardened layer comprises a second surface, the first surface is bonded to the second surface, and the first surface and the second surface are rough surfaces.

16. The flexible cover plate according to claim 15, wherein the first surface and the second surface have micro structures.

17. A flexible display device, comprising a display panel, wherein the flexible display device further comprises a flexible cover plate, a substrate layer of the flexible cover plate is formed on the display panel, the flexible cover plate comprises a bending region, a non-bending region, and a transition region, the transition region is connected to the non-bending region and the bending region, and the flexible cover plate further comprises:
at least one of the substrate layer; and
at least one hardened layer formed on the substrate layer;
wherein a thickness of a portion of the hardened layer located in the bending region is less than a thickness of a portion of the hardened layer located in the non-bending region, and a thickness of a portion of the substrate layer located in the bending region is greater than a thickness of a portion of the substrate layer located in the non-bending region.

18. The flexible display device according to claim 17, wherein the thickness of the portion of the hardened layer located in the bending region is less than the thickness of the portion of the substrate layer located in the bending region.

19. The flexible display device according to claim 17, wherein the substrate layer comprises a first bending portion, a first non-bending portion, and a first transition portion, and the first transition portion is connected to the first non-bending portion and the first bending portion; and the hardened layer comprises a second bending portion, a second non-bending portion, and a second transition portion, and the second transition portion is connected to the second non-bending portion and the second bending portion;
wherein the first bending portion and the second bending portion are located in the bending region, the first non-bending portion and the second non-bending portion are located in the non-bending region, and the first transition portion and the second transition portion are located in the transition region; and
wherein the second bending portion is formed correspondingly on the first bending portion, the second non-bending portion is formed correspondingly on the first non-bending portion, and the second transition portion is formed correspondingly on the first transition portion.

20. The flexible display device according to claim 19, wherein a thickness of the first bending portion is greater than a thickness of the first non-bending portion; and a thickness of the second bending portion is less than a thickness of the second non-bending portion.
